# EUROPEAN PATENT APPLICATION

(11) **EP 4 746 608 A1**
(43) Date of publication of application: **20.05.2026**
(21) Application number: 24905558.3
(22) Date of filing: 06.08.2024
(51) Int. Cl.: H05K 7/20

(54) **VAPOR CHAMBER AND ELECTRONIC DEVICE**

(30) Priority: 21.12.2023 CN 202311777226
(71) Applicant: Honor Device Co., Ltd., Shenzhen, Guangdong 518040 (CN)
(72) Inventor: ZHENG, Wenqiang, Shenzhen, Guangdong 518040 (CN); WEI, Zhenhong, Shenzhen, Guangdong 518040 (CN); LI, Zhimei, Shenzhen, Guangdong 518040 (CN)
(74) Representative: Gill Jennings & Every LLP
(86) International application number: PCT/CN2024/110172
(87) International publication number: WO 2025/130062

(57) **Abstract**

This application provides a vapor chamber and an electronic device, and relates to the field of electronic device technologies, to resolve a problem of high thermal resistance of a vapor chamber, resulting in poor heat dissipation performance and poor heat dissipation effect of internal elements of an electronic device. For the vapor chamber, the vapor chamber includes a case, a first wick, and at least one second wick. The case includes a first cover plate and a second cover plate, and the first cover plate includes an evaporation region and a condensation region. The first wick is disposed in the case. The first wick is attached to the first cover plate and spaced apart from the second cover plate. The first wick covers the evaporation region and the condensation region. The second wick is disposed in the case and covers the evaporation region. The second wick and the first wick are stacked.

## Description

This application claims priority to Chinese Patent Application No. 202311777226.8, filed with the China National Intellectual Property Administration on December 21, 2023 and entitled "VAPOR CHAMBER AND ELECTRONIC DEVICE", which is incorporated herein by reference in its entirety.

### TECHNICAL FIELD

This application relates to the field of electronic device technologies, and in particular, to a vapor chamber and an electronic device.

### BACKGROUND

With continuous development of electronic devices (such as mobile phones), heat generated by some elements in an electronic device continuously increases. Therefore, a vapor chamber (VC, Vapor Chamber) is disposed in the electronic device, to dissipate heat from elements generating large amounts of heat. However, an existing vapor chamber has high thermal resistance, resulting in poor heat dissipation performance and poor heat dissipation effect of internal elements of the electronic device.

### SUMMARY

Embodiments of this application provide a vapor chamber and an electronic device, to resolve a problem of high thermal resistance of a vapor chamber, resulting in poor heat dissipation performance and poor heat dissipation effect of internal elements of an electronic device.

To achieve the foregoing objectives, the following technical solutions are used in embodiments of this application.

According to a first aspect, a vapor chamber is provided. The vapor chamber includes a case, a first wick, and at least one second wick. The case includes a first cover plate and a second cover plate, and the first cover plate includes an evaporation region and a condensation region. The first wick is disposed in the case. The first wick is attached to the first cover plate and spaced apart from the second cover plate. The first wick covers the evaporation region and the condensation region. The second wick is disposed in the case and covers the evaporation region. The second wick and the first wick are stacked.

In the vapor chamber provided in the first aspect of this application, on the basis that the first wick is disposed in the case, the at least one second wick is disposed at a position corresponding to the evaporation region, that is, a plurality of wicks are stacked in the evaporation region, to increase a liquid storage amount corresponding to the additional region, so that more heat can be absorbed, and heat dissipation performance can be improved. In addition, a plurality of layers of wicks are all disposed in the case. Therefore, in a heat transfer process, thermal resistance is lower, so that the heat dissipation performance can be further improved.

In a possible implementation of the first aspect of this application, the case further includes a plurality of support pillars, and the support pillars are all disposed on the second cover plate and abut against the first wick. In this structure, the support pillars abut between the first wick and the second cover plate, to form support. This avoids a case in which vapor flow is affected due to a reduction in a space between the first wick and the second cover plate.

In a possible implementation of the first aspect of this application, the support pillars includes a first support pillar and a second support pillar, a vertical projection of the first support pillar on the first cover plate is located in the evaporation region, a vertical projection of the second support pillar on the first cover plate is located in the condensation region, and a spacing distance between two adjacent first support pillars is greater than a spacing distance between two adjacent second support pillars. In this structure, a liquid working medium evaporates to form vapor. In a process in which vapor flows from a region in which the first support pillar is located to a region in which the second support pillar is located, because the spacing between the first support pillars is greater than the spacing between the second support pillars, a cross-sectional area of a vapor flow passage decreases. This can increase a vapor flow rate and help enhance vapor flow efficiency.

In a possible implementation of the first aspect of this application, a diameter of the first support pillar is greater than a diameter of the second support pillar. This structure can improve effect and reliability of supporting the first wick and the second wick in the evaporation region by the first support pillar.

In a possible implementation of the first aspect of this application, a length of the first support pillar is greater than a length of the second support pillar. This structure helps increase a space corresponding to the evaporation region, can accommodate more vapor, and helps further improve evaporation efficiency.

In a possible implementation of the first aspect of this application, the second wick includes a first region and a second region, the first region covers the evaporation region, the second region is attached to the condensation region, the second region extends to an end that is of the condensation region and that is away from the evaporation region, and the second support pillar is disposed in a region other than a vertical projection of the second region on the second cover plate. In this way, a vapor passage can be formed between the second region and the second cover plate, so that vapor can quickly flow to the condensation region. In addition, the second region can improve a liquid absorption capability of the condensation region, thereby helping improve heat dissipation performance of the vapor chamber.

In a possible implementation of the first aspect of this application, a distance between the evaporation region and the second cover plate is a first distance, a distance between the condensation region and the second cover plate is a second distance, and the first distance is greater than the second distance; and the first cover plate further includes a transition region, the transition region is connected between the evaporation region and the condensation region, and an included angle formed between the transition region and the second cover plate is an acute angle. In this structure, the transition region is tilted. This helps reduce resistance of a part that is of the first wick and that is attached to the transition region, so that a liquid working medium in the first wick can quickly flow to the evaporation region, thereby improving heat dissipation efficiency.

In a possible implementation of the first aspect of this application, the support pillars further include a third support pillar, and a vertical projection of the third support pillar on the first cover plate is located in the transition region. In this structure, the third support pillar abuts against the first wick attached to the transition region, to ensure that the first wick is closely attached to the transition region.

In a possible implementation of the first aspect of this application, a surface that is of the third support pillar and that faces the transition region is an abutting surface, and the abutting surface and the transition region are disposed parallel to each other. In this structure, face-to-face contact is formed between the third support pillar and the first wick, that is, a contact area between the third support pillar and the first wick is increased, helping improve support reliability.

In a possible implementation of the first aspect of this application, the abutting surface extends from an edge that is of the transition region and that is close to the evaporation region to an edge that is of the transition region and that is close to the condensation region. This structure can further increase a contact area between the abutting surface and the first wick, thereby further improving support reliability.

In a possible implementation of the first aspect of this application, a plurality of third support pillars are disposed, and the plurality of third support pillars are spaced apart from each other along a length direction of the transition region. This structure can further improve support reliability.

In a possible implementation of the first aspect of this application, a part that is of the first wick and that is attached to the transition region is fastened to the transition region. For example, the first wick and the transition region may be fastened through spot soldering.

In a possible implementation of the first aspect of this application, a plurality of heat dissipation holes are provided on an outer wall of the second cover plate, the heat dissipation holes are provided in one-to-one correspondence with the support pillars, and the heat dissipation hole extends along an axial direction of the support pillar. This can increase a contact area between the second cover plate and external air, thereby improving heat dissipation efficiency.

According to a second aspect, an electronic device is provided. The electronic device includes a housing, a heat-generating element, and a vapor chamber, where the vapor chamber is the vapor chamber according to any one of the foregoing technical solutions; both the heat-generating element and the vapor chamber are disposed in the housing; and the heat-generating element is attached to the first cover plate of the vapor chamber, and is located in the evaporation region of the first cover plate.

Because the electronic device provided in the second aspect of this application includes the vapor chamber described in any one of the foregoing technical solutions, a same technical problem can be resolved and same technical effects can be achieved.

### BRIEF DESCRIPTION OF DRAWINGS

FIG. 1 is a diagram of a structure of an electronic device according to an embodiment of this application;
FIG. 2 is an exploded view of an electronic device according to an embodiment of this application;
FIG. 3 is a diagram of a structure of a vapor chamber according to an embodiment of this application;
FIG. 4 is a diagram of a structure of an assembly of stacked vapor chambers according to an embodiment of this application;
FIG. 5 is another diagram of a structure of an assembly of stacked vapor chambers according to an embodiment of this application;
FIG. 6 is another diagram of a structure of a vapor chamber according to an embodiment of this application;
FIG. 7 is still another diagram of a structure of a vapor chamber according to an embodiment of this application;
FIG. 8 is still another diagram of a structure of a vapor chamber according to an embodiment of this application;
FIG. 9 is a diagram of density degrees of a first wick and a second wick according to an embodiment of this application;
FIG. 10 is a diagram of a spacing between first support pillars and a spacing between second support pillars according to an embodiment of this application;
FIG. 11 is a diagram of a structure of a second wick according to an embodiment of this application;
FIG. 12 is a diagram of a structure of a second cover plate according to an embodiment of this application;
FIG. 13 is a diagram of a structure of a first cover plate according to an embodiment of this application;
FIG. 14 is another diagram of a structure of a first cover plate according to an embodiment of this application;
FIG. 15 is a diagram of a partial structure of a manner of connection between a transition region and a first wick according to an embodiment of this application;
FIG. 16 is a diagram of a partial structure of another manner of connection between a transition region and a first wick according to an embodiment of this application; and
FIG. 17 is a diagram of a partial structure of still another manner of connection between a transition region and a first wick according to an embodiment of this application.

Reference numerals: 10: electronic device; 100: display assembly; 110: light-transmitting cover plate; 120: display; 200: housing; 210: rear cover; 220: side frame; 230: middle plate; 300: vapor chamber; 300a: first vapor chamber; 300b: second vapor chamber; 301: lower cover; 301a: first lower cover; 301b: second lower cover; 302: upper cover; 302a: first upper cover; 302b: second upper cover; 303: wick; 303a: wick I; 303b: wick II; 304: double-sided adhesive tape; 305: middle cover plate; 309: case; 310: first cover plate; 311: evaporation region; 312: condensation region; 313: transition region; 320: second cover plate; 321: heat dissipation hole; 330: first wick; 340: second wick; 341: first region; 342: second region; 350: support pillar; 351: first support pillar; 352: second support pillar; 353: third support pillar; 353a: abutting surface; 400: circuit board.

### DESCRIPTION OF EMBODIMENTS

The following describes the technical solutions in embodiments of this application with reference to the accompanying drawings in embodiments of this application. Clearly, the described embodiments are only some rather than all of embodiments of this application.

Terms such as "first" and "second" mentioned below are only intended for a purpose of description, and shall not be understood as an indication or implication of relative importance or implicit indication of a quantity of indicated technical features. Therefore, a feature limited by "first ", "second" and the like may explicitly indicate or implicitly include one or more such features.

In addition, in this application, position terms such as "upper", and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

In this application, unless otherwise specified and limited, the term "connection" should be understood in a broad sense. For example, the "connection" may be fastening, a detachable connection, an integrated connection, a direct connection, or an indirect connection by using an intermediate medium.

An embodiment of this application provides an electronic device. Specifically, the electronic device may be a portable electronic apparatus or another type of electronic apparatus. For example, the electronic device may be a mobile phone, a tablet computer (tablet personal computer), a laptop computer (laptop computer), a personal digital assistant (personal digital assistant, PDA), a monitor, a camera, a personal computer, a notebook computer, a wearable device, or the like. For ease of description, the following uses an example in which the electronic device is a mobile phone for description.

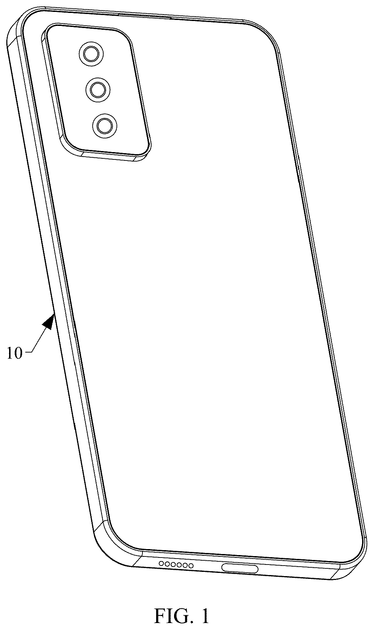

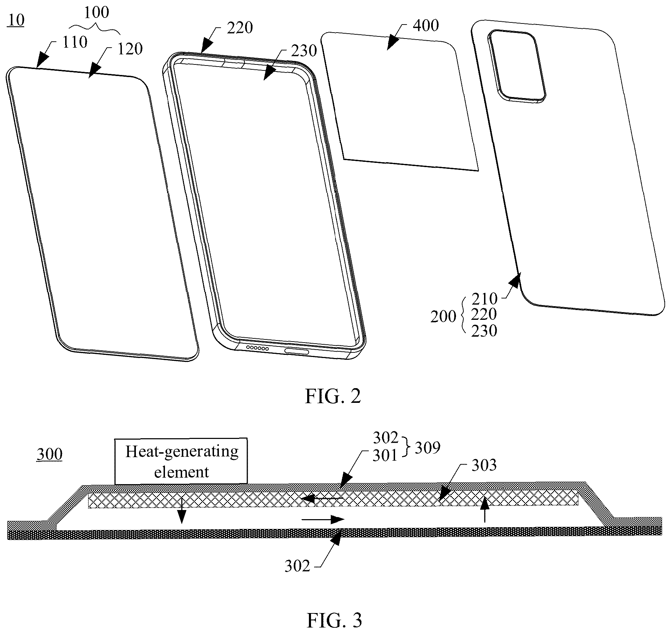

Refer to FIG. 1 and FIG. 2. FIG. 1 is a diagram of a structure of an electronic device 10 according to an embodiment of this application. FIG. 2 is an exploded view of an electronic device 10 according to an embodiment of this application. It may be understood that FIG. 1 and FIG. 2 show only an example of some components included in the electronic device 10, and actual shapes, actual sizes, actual positions, and actual structures of these components are not limited to those in FIG. 1 and FIG. 2.

It can be learned from the foregoing description that, in this embodiment, the electronic device 10 is a mobile phone, and the electronic device 10 may have an approximately rectangular plate structure. The electronic device 10 may include a display assembly 100, a housing 200, a circuit board 400, and components.

The display assembly 100 is configured to display an image, a video, and the like. The display assembly 100 may include a light-transmitting cover plate 110 and a display 120 (English name: panel, also referred to as a display panel), and the light-transmitting cover plate 110 and the display 120 are stacked. A material of the light-transmitting cover plate 110 includes but is not limited to glass. For example, the light-transmitting cover plate 110 may be a common light-transmitting cover plate 110, configured to protect the display 120 to avoid damage to the display 120 due to external force, and prevent dust. Alternatively, the light-transmitting cover plate 110 may be a light-transmitting cover plate 110 having a touch function, so that the electronic device 10 has a touch function, thereby facilitating use of a user. Therefore, a specific material of the light-transmitting cover plate 110 is not specially limited in this application.

In addition, the display 120 may be a flexible display or a rigid display. For example, the display 120 may be an organic light-emitting diode (organic light-emitting diode, OLED) display, an active-matrix organic light-emitting diode (active-matrix organic light-emitting diode, AMOLED) display, a mini light-emitting diode (mini organic light-emitting diode) display, a micro light-emitting diode (micro organic light-emitting diode) display, a micro organic light-emitting diode (micro organic light-emitting diode) display, a quantum dot light-emitting diode (quantum dot light emitting diode, QLED) display, or a liquid crystal display (liquid crystal display, LCD).

The housing 200 is configured to protect an electronic component in the electronic device 10. The housing 200 may include a rear cover 210 and a side frame 220. The rear cover 210 is located on a side that is of the display 120 and that is away from the light-transmitting cover plate 110, and is stacked with the light-transmitting cover plate 110 and the display 120. The side frame 220 is located between the light-transmitting cover plate 110 and the rear cover 210. The side frame 220 is fastened to the rear cover 210. For example, the side frame 220 may be fastened to the rear cover 210 through bonding, threaded connection, soldering, clamping, or the like. Alternatively, the side frame 220 and the rear cover 210 may be an integrated structure, that is, the side frame 220 and the rear cover 210 form an integral mechanical part. The light-transmitting cover plate 110 may be fastened to the side frame 220 through adhesive bonding, so that the light-transmitting cover plate 110, the rear cover 210, and the side frame 220 form an accommodating cavity in the electronic device 10. Both the circuit board components and the electronic component are disposed in the accommodating cavity.

In some embodiments, the housing 200 may further include a middle plate 230. The middle plate 230 is disposed in the accommodating cavity, and the middle plate 230 is located on a side that is of the display 120 and that is away from the light-transmitting cover plate 110. The middle plate 230 and the side frame 220 are fastened to form a middle frame of the electronic device 10. For example, the middle plate 230 and the side frame 220 may be fastened in a manner such as adhesive bonding, threaded connection, soldering, or clamping. Alternatively, the middle plate 230 and the side frame 220 may be an integrated structure, that is, the middle plate 230 and the side frame 220 form an integral mechanical part. The middle plate 230 partitions the accommodating cavity into two mutually independent spaces. One space is located between the light-transmitting cover plate 110 and the middle plate 230, and the display 120 is located in the space. The other space is located between the middle plate 230 and the rear cover 210, and the circuit board components are located in the other space.

The circuit board 400 is configured to dispose the components in the electronic device 10, and implement electrical connection between the components. The circuit board 400 may be fastened to the middle plate 230 in a manner such as adhesive bonding, threaded connection, soldering, or clamping. Therefore, a fastening manner of the circuit board 400 is not specially limited in this application.

The components are configured to implement various functions of the electronic device 10. For example, the component may be a control chip, for example, a system-on-chip (System on Chip, SOC), a graphics control chip (graphics processing unit, GPU), a universal storage (universal flash storage, UFS), a camera module, a flash module, a capacitor, a resistor, an inductor, or the like.

Some components, for example, the SOC chip, can generate heat during operation. These components that can generate heat may also be referred to as heat-generating elements, and are all referred to as heat-generating elements in the following embodiments. To reduce a risk that the heat-generating element is damaged due to a large amount of heat generation, a vapor chamber 300 may be disposed in the housing 200, and heat is dissipated from heat-generating elements generating large amounts of heat by using the vapor chamber 300.

Specifically, refer to FIG. 3. FIG. 3 is a diagram of a structure of a vapor chamber 300 according to an embodiment of this application. The vapor chamber 300 may include a case 309 and a wick 303. The case 309 includes a lower cover 301 and an upper cover 302. The wick 303 is disposed in the case 309, and the wick 303 is filled with a liquid working medium. The heat-generating element is attached to an outer surface of the case 309, that is, an outer wall of the lower cover 301 or an outer wall of the upper cover 302.

When the heat-generating element generates heat, the liquid working medium in the wick 303 absorbs heat (that is, at an evaporation end). After evaporation, the liquid working medium leaves the wick 303 and forms vapor. Vapor can flow within an internal space of the case 309 and flow to a region that is away from the heat-generating element (that is, at a condensation end). After releasing heat in this region, vapor condenses into liquid (namely, the liquid working medium) again. The liquid is then absorbed by the wick 303. Finally, the liquid working medium in the wick 303 flows again to a region in which the heat-generating element is located, thereby forming an evaporation cooling cycle (shown by using arrows in FIG. 3), and implementing heat dissipation.

To further improve heat dissipation performance of the vapor chamber 300, two vapor chambers 300 may be further stacked, to form an assembly of stacked vapor chambers 300. This can increase a heat storage amount of the vapor chambers 300, to improve heat dissipation performance of the vapor chamber 300. In some embodiments, the assembly of stacked vapor chambers may include two vapor chambers 300, and cases 309 of the two vapor chambers 300 are bonded and fastened by using a double-sided adhesive tape 304.

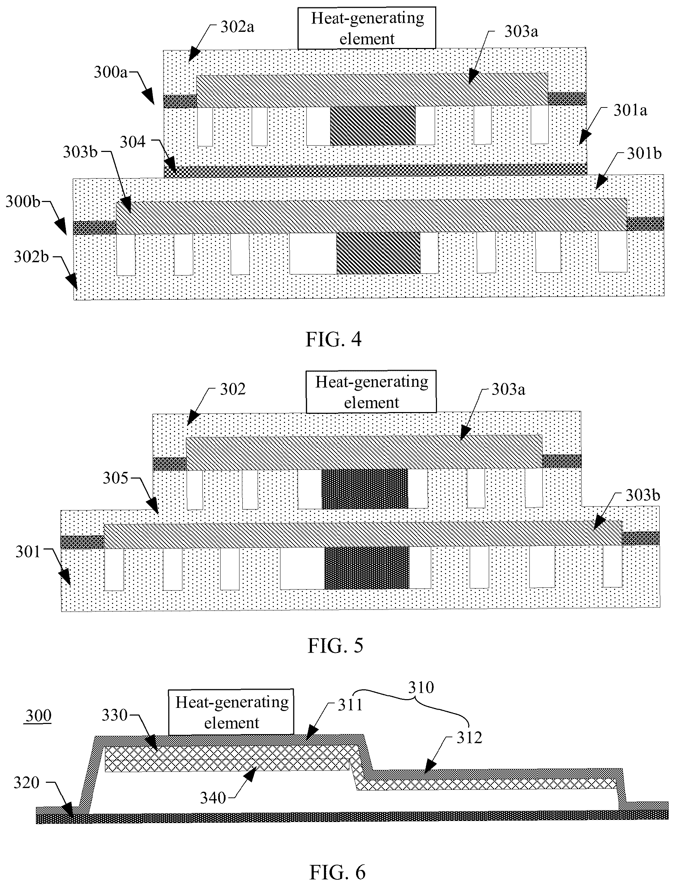

For example, refer to FIG. 4. FIG. 4 is a diagram of a structure of an assembly of stacked vapor chambers according to an embodiment of this application. Two vapor chambers 300 are a first vapor chamber 300a and a second vapor chamber 300b. The first vapor chamber 300a includes a first lower cover 301a, a first upper cover 302a, and a wick I 303a. The second vapor chamber 300b includes a second lower cover 301b, a second upper cover 302b, and a wick II 303b. The heat-generating element may be attached to an outer wall of the first upper cover 302a.

When the heat-generating element generates heat, heat needs to be transferred in the following sequence: the first upper cover 302a, the wick I 303a, the first lower cover 301a, the double-sided adhesive tape 304, the second upper cover 302b, the wick II 303b, and the second lower cover 301b. In other words, Total thermal resistance=Thermal resistance of the first upper cover 302a+Thermal resistance of the wick I 303a+Thermal resistance of the first lower cover 301a+Thermal resistance of the double-sided adhesive tape 304+Thermal resistance of the second upper cover 302b+Thermal resistance of the wick II 303b+Thermal resistance of the second lower cover 301b.

Alternatively, refer to FIG. 5. FIG. 5 is a diagram of a structure of another assembly of stacked vapor chambers according to an embodiment of this application. The assembly of stacked vapor chambers may include a lower cover 301, a middle cover plate 305, and an upper cover 302. A sealed cavity is formed between the lower cover 301 and the middle cover plate 305. A sealed cavity is formed between the upper cover 302 and the middle cover plate 305. The two sealed cavities are provided with a wick I 303a and a wick II 303b, and are filled with a liquid working medium, thereby forming a stacked structure.

For example, the heat-generating element is attached to an outer wall of the upper cover 302. When the heat-generating element generates heat, heat needs to be transferred in the following sequence: the upper cover 302, the wick I 303a, the middle cover plate 305, the wick II 303b, and the lower cover 301. In other words, in a heat transfer process, Total thermal resistance=Thermal resistance of the upper cover 302+Thermal resistance of the wick I 303a+Thermal resistance of the middle cover plate 305+Thermal resistance of the wick II 303b+Thermal resistance of the lower cover 301.

It can be learned that, during operation of the assembly of stacked vapor chambers 300, there is high thermal resistance during heat transfer. Therefore, an overall heat dissipation capability is affected, and heat dissipation effect of the heat-generating element in the electronic device 10 is poor.

To resolve the foregoing problem, refer to FIG. 6. FIG. 6 is a diagram of a structure of another vapor chamber 300 according to an embodiment of this application. The vapor chamber 300 may be used in the electronic device 10. In addition, the vapor chamber 300 may be fastened to a middle frame of the electronic device 10 in a manner such as adhesive dispensing, adhesive dispensing plus adhesive backing, large-area adhesive backing plus partial adhesive dispensing, or the like. This is not specially limited in this application. The vapor chamber 300 includes a case 309, a first wick 330, and at least one second wick 340.

The case 309 includes a first cover plate 310 and a second cover plate 320. The first cover plate 310 and the second cover plate 320 are mutually interlocked and fastened. A cavity is formed between the first cover plate 310 and the second cover plate 320. The first cover plate 310 includes an evaporation region 311 and a condensation region 312. The first wick 330 is disposed in the case 309, where the first wick 330 is attached to the first cover plate 310 and spaced apart from the second cover plate 320, and the first wick 330 covers the evaporation region 311 and the condensation region 312. The second wick 340 is disposed in the case 309 and covers the evaporation region 311, where the second wick 340 and the first wick 330 are stacked.

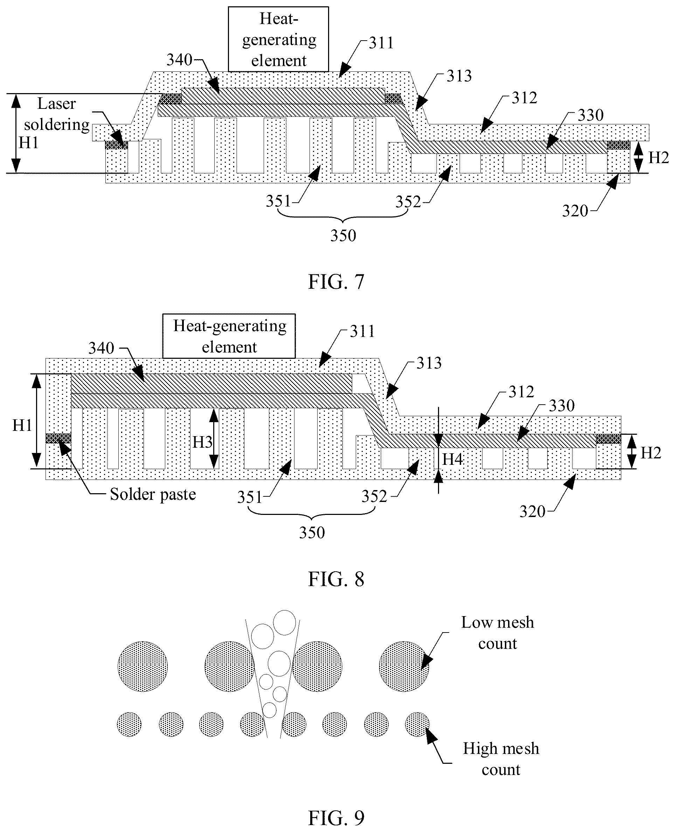

In some embodiments, still refer to FIG. 6. The second wick 340 may alternatively be disposed on a side that is of the first wick 330 and that is away from the first cover plate 310. Alternatively, refer to FIG. 7. FIG. 7 is a diagram of a structure of still another vapor chamber 300 according to an embodiment of this application. The second wick 340 may be disposed between the first wick 330 and the first cover plate 310. In addition, one second wick 340 may be disposed, or a plurality of second wicks 340 may be disposed according to an actual requirement. Therefore, this is not specially limited in this application. In the following embodiments, an example in which one second wick 340 is disposed between the first wick 330 and the first cover plate 310 is used for description.

In this way, on the basis that the first wick 330 is disposed in a case 309, the at least one second wick 340 is disposed at a position corresponding to an evaporation region 311, that is, a plurality layers of wicks 303 are stacked in the evaporation region 311, to increase a liquid storage amount corresponding to the evaporation region 311, so that more heat can be absorbed, and heat dissipation performance can be improved. In addition, a plurality of layers of wicks 303 are all disposed in the case 309. Therefore, in a heat transfer process, thermal resistance is lower, so that the heat dissipation performance can be further improved. In addition, the plurality of layers of wicks 303 are disposed only in a space corresponding to the evaporation region 311. Then, only a thickness at the evaporation region 311 of the first cover plate 310 needs to be increased, and a size of a condensation region 312 does not need to be increased.

In some embodiments, still refer to FIG. 7. When the first cover plate 310 and the second cover plate 320 are mutually interlocked to form the case 309, a distance between the evaporation region 311 of the first cover plate 310 and the second cover plate 320 is a first distance H1. A distance between the condensation region 312 of the first cover plate 310 and the second cover plate 320 is a second distance H2. The first distance H1 is greater than the second distance H2. That is, the evaporation region 311 and the condensation region 312 are connected through a transition region 313 (for details, refer to the following embodiment).

In this way, a plurality of layers of second wicks 340 may be stacked in the evaporation region 311 of the first cover plate 310, to increase a liquid storage amount of wicks 303 in the evaporation region 311. This further helps improve a heat absorption capability and improve heat dissipation performance.

For example, the first cover plate 310 and the second cover plate 320 may be formed through stamping, that is, a stamping process is performed on an inner surface of the first cover plate 310 and an inner surface of the second cover plate 320, to form a groove structure on the inner surface of the first cover plate 310 and the inner surface of the second cover plate 320. When the two cover plates are mutually interlocked, the case 309 with an internal cavity can be formed. When a stamping process is performed on the first cover plate 310, a depth of a groove structure formed in the evaporation region 311 may be greater than a depth of a groove in the condensation region 312. Therefore, after the first cover plate 310 and the second cover plate 320 are mutually interlocked, the first distance may be greater than the second distance.

In addition, the first cover plate 310 and the second cover plate 320 may be fastened through laser soldering. For example, the first cover plate 310 and the second cover plate 320 may be made of a stainless steel material and fastened through laser soldering.

Alternatively, refer to FIG. 8. FIG. 8 is still another diagram of a structure of a vapor chamber 300 according to an embodiment of this application. The first cover plate 310 and the second cover plate 320 may be alternatively formed through etching. To be specific, an etching process is performed on an inner surface of the first cover plate 310 and an inner surface of the second cover plate 320, to form a groove structure on the inner surface of the first cover plate 310 and the inner surface of the second cover plate 320. When the two cover plates are mutually interlocked, the case 309 with an internal cavity can be formed. When the first cover plate 310 is etched, groove structures with different depths may be formed. Therefore, after the first cover plate 310 and the second cover plate 320 are mutually interlocked, the first distance may be greater than the second distance.

In addition, the first cover plate 310 and the second cover plate 320 may be fastened by using a solder paste. For example, the first cover plate 310 and the second cover plate 320 may be made of metal copper and fastened by using the solder paste.

In addition, the first wick 330 and the second wick 340 may be fastened to the first cover plate 310 through spot soldering, thereby further improving overall structural strength. In addition, the first wick 330 and the second wick 340 may be wicks 303 with different density degrees (different mesh counts).

For example, refer to FIG. 9. FIG. 9 is a diagram of density degrees of a first wick 330 and a second wick 340 according to an embodiment of this application. The second wick 340 may be a high mesh-count wick 303, and the first wick 330 may be a low mesh-count wick 303. In this case, due to a higher mesh count of the second wick 340, a bubble generated through evaporation of a liquid working medium in the second wick 340 is smaller, that is, a flow passage of the bubble has a smaller space. Due to a lower mesh count of the first wick 330, a bubble generated through evaporation of a liquid working medium in the first wick 330 is larger, that is, a flow passage of the bubble has a larger space. In this way, the smaller bubble generated in the second wick 340 can press against the larger bubble in the first wick 330, to promote an evaporation cycle and improve evaporation efficiency.

In some other possible examples, the second wick 340 may alternatively be a low mesh-count wick 303, and the first wick 330 may alternatively be a high mesh-count wick. In this case, permeability of the wick 303 decreases as a mesh count increases. In other words, a high mesh-count wick has low permeability. Therefore, the second wick 340 is a low mesh-count wick, and the first wick 330 is a high mesh-count wick. This helps reduce flow resistance, thereby reducing a risk of the wick evaporating to dryness.

Because the first wick 330 and the second cover plate 320 are spaced apart from each other, after absorbing heat and forming vapor, the liquid working medium can flow in a space between the first wick 330 and the second cover plate 320. To prevent the space between the first wick 330 and the second cover plate 320 from gradually decreasing during use, as shown in FIG. 7 and FIG. 8, the vapor chamber 300 provided in this embodiment of this application further includes a plurality of support pillars 350. The plurality of support pillars 350 are disposed on an inner wall of the second cover plate 320, and free ends of the support pillars 350 abut against the first wick 330.

Based on this, the plurality of support pillars 350 are disposed between the second cover plate 320 and the first wick 330. In this way, effective support can be formed between the second cover plate 320 and the first wick 330, avoiding a reduction in a space between the first wick 330 and the second cover plate 320 due to a dent in the first cover plate 310 or the second cover plate 320. In addition, the support pillar 350 abuts against the first wick 330, so that it can be ensured that the first wick 330 and the first cover plate 310 are attached to each other, and the second wick 340 and the first cover plate 310 are attached to each other, preventing the first wick 330 and the second wick 340 from separating from the first cover plate 310, thereby ensuring heat dissipation effect.

In some embodiments, the plurality of support pillar 350 includes a plurality of first support pillars 351 and a plurality of second support pillars 352, vertical projections of the plurality of first support pillars 351 on the first cover plate 310 are located in the evaporation region 311, vertical projections of the plurality of second support pillars 352 on the first cover plate 310 are located in the condensation region 312, and a spacing distance between two adjacent first support pillars 351 is greater than a spacing distance between two adjacent second support pillars 352.

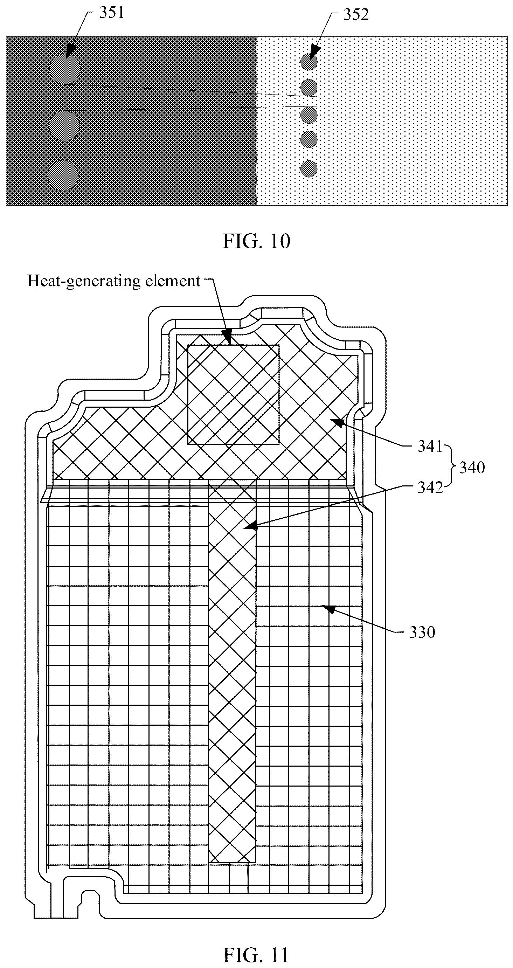

In this case, refer to FIG. 10. FIG. 10 is a diagram of a spacing between first support pillars 351 and a spacing between second support pillars 352 according to an embodiment of this application. When vapor flows from a region in which the first support pillar 351 is located to a region in which the second support pillar 352 is located, because the spacing between the first support pillar 351 is greater than the spacing between the second support pillar 352, that is, a flow cross section of vapor decreases. This can increase a vapor flow rate. It can be learned through an experiment that this structure can increase the vapor flow rate by 85%. Therefore, heat can quickly flow to a space corresponding to the condensation region 312. When vapor condenses into liquid, the liquid is absorbed by the wick 303, and a cycle continues.

In addition, a diameter of the first support pillar 351 may be greater than a diameter of the second support pillar 352. This structure helps improve support strength of the first support pillar 351, and ensures that the first wick 330 and the second wick 340 are attached to each other, and are in contact with the first cover plate 310, thereby ensuring heat absorption and evaporation efficiency.

In addition, a length of the first support pillar 351 may be greater than a length of the second support pillar 352 (as shown in FIG. 8). That is, in a region corresponding to the evaporation region 311, a distance between the first wick 330 and the second cover plate 320 is a third distance H3; in a region corresponding to the condensation region 312, a distance between the first wick 330 and the second cover plate 320 is a fourth distance H4, where the third distance H3 is greater than the fourth distance H4. This structure helps increase a space corresponding to the evaporation region 311, can accommodate more vapor, and helps further improve evaporation efficiency.

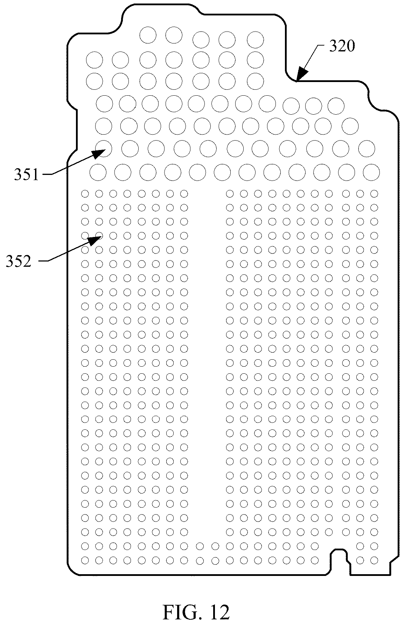

In some other embodiments, refer to FIG. 11 and FIG. 12. FIG. 11 is a diagram of a structure of a second wick according to an embodiment of this application. FIG. 12 is a diagram of a structure of a second cover plate 320 according to an embodiment of this application. The second wick 340 may include a first region 341 and a second region 342. The first region 341 covers the evaporation region 311 of the first cover plate 310. The second region 342 is attached to the condensation region 312, and the second region 342 extends to an end that is of the condensation region 312 and that is away from the evaporation region 311. The second support pillars 352 are all disposed in a region other than a vertical projection of the second region 342 on the second cover plate 320.

In this way, the second region 342 of the second wick 340 is disposed in the condensation region 312, and the second support pillar 352 is not disposed in a corresponding region, so that a vapor passage can be formed between the second region 342 and the second cover plate 320. The second region 342 can improve a liquid absorption capability of the condensation region 312. In addition, there is no vapor resistance in the vapor passage. This facilitates fast flow of vapor, thereby improving evaporative cooling cycle efficiency.

For example, still refer to FIG. 11 and FIG. 12. An end that is of the second region 342 of the second wick 340 and that is connected to the first region 341 may be disposed at a position closest to a heat source (namely, the heat-generating element). In this way, a part of heat can quickly flow to the condensation region 312 through the vapor passage formed between the second region 342 and the second cover plate 320, and is cooled to liquid, to improve circulation efficiency.

On this basis, because the evaporation region 311 and the condensation region 312 of the first cover plate 310 are not located on a same plane, the first cover plate 310 further includes the transition region 313 (as shown in FIG. 7 and FIG. 8), and an included angle formed between the transition region 313 and the second cover plate 320 is an acute angle, that is, 0° to 90°. In addition, along a direction from the evaporation region 311 to the condensation region 312, a length of the transition region 313 ranges from 0.3 mm to 5 mm.

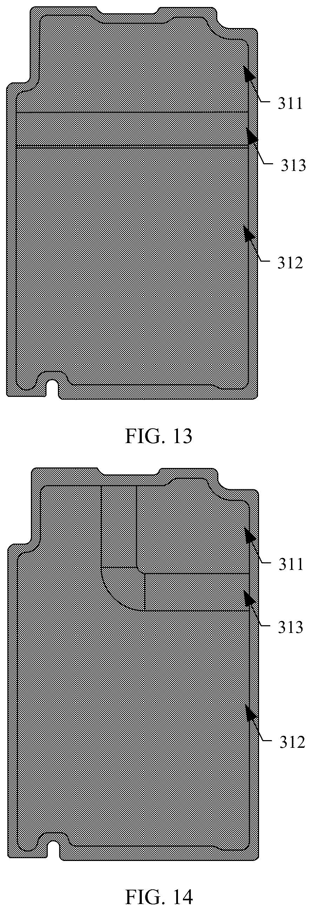

For example, refer to FIG. 13. FIG. 13 is a diagram of a structure of a first cover plate 310 according to an embodiment of this application. The transition region 313 may form a straight line structure, that is, may extend along a direction. Alternatively, refer to FIG. 14. FIG. 14 is a diagram of a structure of another first cover plate 310 according to an embodiment of this application. The transition region 313 may alternatively be of a bent structure, that is, may extend in a plurality of directions. Therefore, the first cover plate 310 can be partitioned into the evaporation region 311 and the condensation region 312 by using the transition region 313. Therefore, a specific structure of the transition region 313 is not specially limited in this application.

In this way, the transition region 313 extends in a tilted manner, so that a part that is of the first wick 330 and that is attached to the transition region 313 can be better attached to the transition region 313, to ensure that no large resistance is generated in the part that is of the first wick 330 and that is attached to the transition region 313, thereby ensuring that the liquid working medium can flow normally.

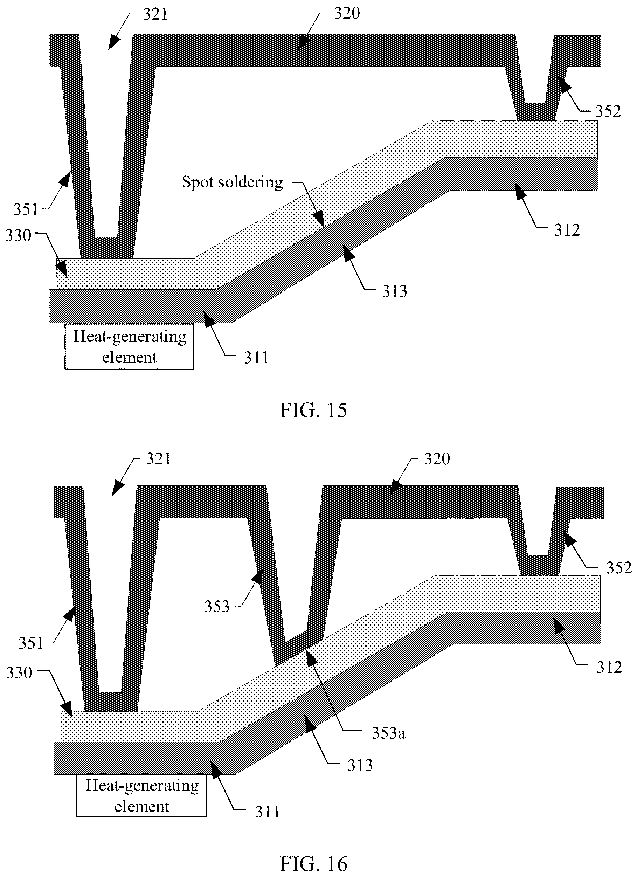

In addition, to avoid that the part that is of the first wick 330 and that is attached to the transition region 313 is not closely attached to the transition region 313, in some embodiments, as shown in FIG. 15, a diagram of a partial structure of a manner of connection between a transition region 313 and a first wick 330 according to an embodiment of this application, the transition region 313 and the first wick 330 may be fastened through spot soldering. This ensures that the first wick 330 is closely attached to the transition region 313, so that the liquid working medium in the first wick 330 can absorb heat and normally evaporate.

In some other embodiments, refer to FIG. 16. FIG. 16 is a diagram of a partial structure of another manner of connection between a transition region 313 and a first wick 330 according to an embodiment of this application. The plurality of support pillars 350 may further include a third support pillar 353. A vertical projection of the third support pillar 353 on the first cover plate 310 is located in the transition region 313. That is, the third support pillar 353 abuts against the first wick 330, to ensure that the first wick 330 is closely attached to the transition region 313. In addition, the third support pillar 353 can support the transition region 313, helping further improve reliability of an overall structure.

For example, a surface that is of the third support pillar 353 and that faces the transition region 313 is an abutting surface 353a, and the abutting surface 353a and the transition region 313 are disposed parallel to each other. In other words, the third support pillar 353 and the first wick 330 can be attached to and abut against each other face to face. This helps increase a contact area between the third support pillar 353 and the first wick 330, and further helps ensure that the first wick 330 and the transition region 313 are closely attached to each other.

In addition, one third support pillar 353 may be disposed, or a plurality of third support pillars 353 may be disposed according to an actual requirement. When only one third support pillar 353 is disposed, the third support pillar 353 may be disposed in a middle region of the transition region 313, to ensure stable support. When the plurality of third support pillars 353 are disposed, the plurality of third support pillars 353 may be spaced apart from each other.

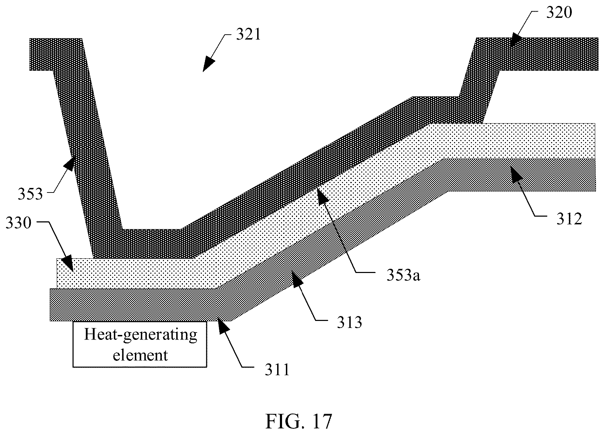

In addition, refer to FIG. 17. FIG. 17 is a diagram of a partial structure of still another manner of connection between a transition region 313 and a first wick 330 according to an embodiment of this application. The abutting surface 353a of the third support pillar 353 may extend from an edge that is of the transition region 313 and that is close to the evaporation region 311 to an edge that is of the transition region 313 and that is close to the condensation region 312. This can further increase a contact area between the abutting surface 353a and the first wick 330, thereby further improving support effect.

In some other possible examples, an end part that is of the third support pillar 353 and that abuts against the first wick 330 may be of a circular structure, a square structure, or the like. Therefore, this is not specially limited in this application.

Based on this, to further improve the heat dissipation effect of the vapor chamber 300, a plurality of heat dissipation holes 321 may be provided on an outer wall of the second cover plate 320, the heat dissipation holes 321 are provided in one-to-one correspondence with the support pillars 350, and the heat dissipation hole 321 extends along an axial direction of the support pillar 350. That is, a hollow structure is formed in the middle of each support pillar 350. This helps increase a contact area between the outer wall of the second cover plate 320 and external air, and further helps improve heat dissipation efficiency, thereby improving heat dissipation performance of the vapor chamber 300.

In the descriptions of this specification, specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A vapor chamber, comprising:
a case, wherein the case comprises a first cover plate and a second cover plate, and the first cover plate comprises an evaporation region and a condensation region;
a first wick, disposed in the case, wherein the first wick is attached to the first cover plate and spaced apart from the second cover plate, and the first wick covers the evaporation region and the condensation region; and
at least one second wick, disposed in the case, and covering the evaporation region, wherein the second wick and the first wick are stacked.

2. The vapor chamber according to claim 1, wherein the case further comprises a plurality of support pillars, and the support pillars are all disposed on the second cover plate and abut against the first wick.

3. The vapor chamber according to claim 2, wherein the support pillars comprise a first support pillar and a second support pillar, a vertical projection of the first support pillar on the first cover plate is located in the evaporation region, a vertical projection of the second support pillar on the first cover plate is located in the condensation region, and a spacing distance between two adjacent first support pillars is greater than a spacing distance between two adjacent second support pillars.

4. The vapor chamber according to claim 3, wherein a diameter of the first support pillar is greater than a diameter of the second support pillar.

5. The vapor chamber according to claim 3, wherein a length of the first support pillar is greater than a length of the second support pillar.

6. The vapor chamber according to claim 3, wherein the second wick comprises a first region and a second region, the first region covers the evaporation region, the second region is attached to the condensation region, the second region extends to an end that is of the condensation region and that is away from the evaporation region, and the second support pillar is disposed in a region other than a vertical projection of the second region on the second cover plate.

7. The vapor chamber according to any one of claims 2 to 6, wherein a distance between the evaporation region and the second cover plate is a first distance, a distance between the condensation region and the second cover plate is a second distance, and the first distance is greater than the second distance; and
the first cover plate further comprises a transition region, the transition region is connected between the evaporation region and the condensation region, and an included angle formed between the transition region and the second cover plate is an acute angle.

8. The vapor chamber according to claim 7, wherein the support pillars further comprise a third support pillar, and a vertical projection of the third support pillar on the first cover plate is located in the transition region.

9. The vapor chamber according to claim 8, wherein a surface that is of the third support pillar and that faces the transition region is an abutting surface, and the abutting surface and the transition region are disposed parallel to each other.

10. The vapor chamber according to claim 9, wherein the abutting surface extends from an edge that is of the transition region and that is close to the evaporation region, to an edge that is of the transition region and that is close to the condensation region.

11. The vapor chamber according to claim 10, wherein a plurality of third support pillars are disposed, and the plurality of third support pillars are spaced apart from each other along a length direction of the transition region.

12. The vapor chamber according to claim 7, wherein a part that is of the first wick and that is attached to the transition region is fastened to the transition region.

13. The vapor chamber according to any one of claims 2 to 12, wherein a plurality of heat dissipation holes are provided on an outer wall of the second cover plate, the heat dissipation holes are provided in one-to-one correspondence with the support pillars, and the heat dissipation hole extends along an axial direction of the support pillar.

14. An electronic device, comprising a housing, a heat-generating element, and a vapor chamber, wherein the vapor chamber is the vapor chamber according to any one of claims 1 to 13; both the heat-generating element and the vapor chamber are disposed in the housing; and the heat-generating element is attached to the first cover plate of the vapor chamber, and is located in the evaporation region of the first cover plate.
